# EUROPÄISCHE PATENTSCHRIFT

(11) **EP 2 485 914 B1**
(45) Veröffentlichungstag und Bekanntmachung des Hinweises auf die Patenterteilung: **06.03.2019**
(21) Anmeldenummer: 10751858.1
(22) Anmeldetag: 18.08.2010
(51) Int. Cl.: B60L 11/18

(54) **VERFAHREN ZUR INITIALISIERUNG UND ZUM BETRIEB EINES BATTERIEMANAGEMENTSYSTEMS**
METHOD FOR INITIALIZING AND OPERATING A BATTERY MANAGEMENT SYSTEM
PROCÉDÉ D'INITIALISATION ET DE FONCTIONNEMENT D'UN SYSTÈME DE GESTION DE BATTERIE

(30) Priorität: 09.10.2009 DE 102009045526
(43) Veröffentlichungstag der Anmeldung: 15.08.2012
(73) Patentinhaber: Samsung SDI Co., Ltd., Gyeonggi-do (KR); Robert Bosch GmbH, 70442 Stuttgart (DE)
(72) Erfinder: BOEHM, Andre, 70806 Kornwestheim (DE); WICKERT, Stefan, 73095 Albershausen (DE)
(74) Vertreter: Bee, Joachim
(86) Internationale Anmeldenummer: PCT/EP2010/062032
(87) Internationale Veröffentlichungsnummer: WO 2011/042245

(56) Entgegenhaltungen:
- EP-A2- 1 801 606
- EP-A2- 1 897 772
- US-A1- 2008 036 421

## Beschreibung

### Stand der Technik

Ein Hybrid- oder Elektrofahrzeug verwendet elektrische Energie, die in einer Batterie gespeichert ist, als Energiequelle. Für den Betrieb einer solchen Batterie ist es dabei entscheidend, feststellen zu können, in welchem Zustand die Batterie ist und welche Kapazität sie für den weiteren Betrieb hat. Dazu wird der Betrieb der Batterie mittels eines Batteriemanagementsystems verwaltet. So werden in Hybrid- und Elektrofahrzeugen Batteriepacks in Li-Ionen oder NiMH-Technologie eingesetzt, die aus einer großen Anzahl in Serie und oder parallel geschalteten elektrochemischen Zellen bestehen. Das Batteriemanagementsystem dient zur Überwachung der Batterie und soll neben der Sicherheitsüberwachung eine möglichst hohe Lebensdauer gewährleisten.

Für die Batterieverwaltung wird die Spannung jeder einzelnen Zelle zusammen mit dem Batteriestrom und der Batterietemperatur gemessen und eine Zustandsschätzung von z.B. dem Ladezustand und dem Alterungszustand vorgenommen. Um die Lebensdauer zu maximieren ist es notwendig, jederzeit die aktuelle maximale Leistungsfähigkeit der Batterie zu kennen. Wird diese Leistungsgrenze überschritten, kann die Alterung der Batterie rapide beschleunigt werden.

Zur Bestimmung des Batteriezustands, insbesondere des Ladezustands, dem sogenannten SOC (state of Charge), sind Verfahren bekannt, die währende des Betriebs aktiv sind. Diese beruhen auf dem Zusammenhang von BatterieSpannung und SOC. Dabei ist jedoch die Leerlaufspannung OCV (open circuit voltage) relevant. Da die Verfahren während des Betriebs aktiv sind, muss die gemessene Spannung um den durch den fließenden Strom und den Innenwiderstand der Batterie verursachten Spannungsabfall korrigiert werden. Dazu werden Impedanz-Modelle eingesetzt, die fehlerbehaftet sind. So offenbart die DE 100 10 980 A1 ein Batteriemanagementsystem zur Bestimmung des Ladezustands der Batterie aus der Messung des Innenwiderstandes Rᵢ. Der einzige Zeitpunkt, zu dem die richtige OCV gemessen werden kann, ist beim Starten des Systems nach einer Pause, also bei der Initialisierung.

Aus der US 2008/0036421 A1 ist ein Verfahren zum Betrieb einer Batterie bekannt, bei dem zu Initialisierung des Ladungszustands eine Fallunterscheidung zwischen einem abgespeicherten, historischen Ladungszustand und einem aus einem Kennlinienfeld ausgelesenen Ladungszustand vorgenommen wird.

### Offenbarung der Erfindung

Die Erfindung bezieht sich auf ein Verfahren zur Bestimmung des Ladezustandes sowie des Alterungszustandes einer Batterie, wobei eine Ladezustandsschätzung unter Berücksichtigung eines zuletzt gespeicherten Ladezustands erfolgt.

Entsprechend wird erfindungsgemäß ein Verfahren zur Initialisierung und zum Betrieb eines Batteriemanagementsystems vorgeschlagen, welches die folgenden Schritte umfasst: Starten des Batteriemanagementsystems; Auslesen von in einem nichtflüchtigen Speicher der Batterie gespeicherten Batteriegrößen umfassend den letzten Ladezustand SOCₐₗₜ der Batterie; Messung der Leerlaufspannung OCV der Batterie; Ermittlung eines aktuellen Ladezustandswertes SOCₐₖₜ in Abhängigkeit von der gemessenen Leerlaufspannung OCV; Ermittlung eines Schätzwertes des Ladezustands der Batterie SOC_{schätz} als Funktion sowohl des gespeicherten letzten Ladezustands der Batterie SOCₐₗₜ als auch des aktuellen Ladezustandwertes SOCₐₖₜ; Initialisierung des Ladezustands im Batteriemanagementsystems mit dem ermittelten Schätzwert des Ladezustands SOC_{schätz}; und schließlich Betrieb des Batteriemanagementsystems mit den initialisierten Werten. Dabei erfolgt vor dem Abschalten des Batteriemanagementsystem oder der Initialisierung ferner eine weitere Plausibilisierung der Werte mittels eines Vergleichs des Leerlaufspannungs-abhängigen berechneten Ladezustand SOCₐₖₜ mit einem Strom-Integral.

Die vorgeschlagene erfindungsgemäße Initialisierung des Batteriemanagementsystems verwendet nicht nur einen gemessenen bzw. berechneten Ladezustandswerte SOCₐₖₜ, sondern berücksichtigt bei der Schätzung des Ladezustands auch den zuletzt abgespeicherten Ladezustand SOCₐₗₜ, der dem Ladezustand beim letzten Abschalten des Batteriemanagementsystems entspricht.

Dass Verfahren umfasst eine Plausibilisierung der Zustandserkennung des Batteriemanagementsystems. Die Plausibilisierung basiert dabei auf einem Vergleich von aktuell berechnetem Ladezustandswert SOCₐₖₜ und zuletzt gespeichertem Ladezustand SOCₐₗₜ. Liegt die Differenz dieser beiden Werte über einem vorbestimmten Schwellenwert, so ist ein Systemfehler oder ein Defekt wahrscheinlich. In diesem Falle kann die Batterie abgeschaltet werden. Geringe Abweichungen können auch auf eine Alterung hinweisen und für die SOC-Berechnung während des Betriebs durch einen Faktor berücksichtigt werden. Dieser Faktor könnte bei der Berechnung des SOC während des Betriebes der Batterie Einfluß finden. Liegt die Differenz unter dem vorbestimmten Schwellenwert, dann wird die Initialisierung des Batteriemanagementsystems mit dem ermittelten Schätzer des Ladezustands SOC_{schätz} durchgeführt. Durch Verwendung des zuletzt abgespeicherten Ladezustands SOCₐₗₜ beim Herunterfahren des Systems kann also eine Sicherheitskontrolle der Batterie erfolgen und somit eine Schädigung der Batterie infolge eines Defektes gleich beim Systemstart vermieden werden. Ähnliches kann für die Plausibilisierung der Werte vor dem Abschalten des Batteriemanagementsystem oder der Initialisierung gelten. Eine Differenzbildung der verglichenen Werte ergibt wie oben dann, ob die Batterie abzuschalten ist, die künftige Integration zur Ermittlung des SOC aufgrund einer Alterung mit einem Faktor zu korrigieren ist und/oder initialisiert werden kann.

Die Ermittlung des aktuellen Ladezustands SOCₐₖₜ kann dabei mittels der gemessenen Leerlaufspannung OCV und eines Temperatur/Leerlaufspannungs-abhängigen Kennfeldes erfolgen. Sie basiert also auf der korrekt gemessenen OCV beim Starten der Batterie. Impedanzmodelle des Standes der Technik sind hier nicht notwendig.

Die Ermittlung des Ladezustandschätzwertes SOC_{schätz} kann in einer Implementierung durch gewichtete Mittelwertbildung aus dem gespeicherten letzten Ladezustand SOCₐₗₜ und dem aktuellen Ladezustand SOCₐₖₜ erfolgen. Dies ermöglicht eine einfache Umsetzung der Berücksichtigung des letzten Ladezustands SOCₐₗₜ beim Abschalten der Batterie.

In einem Ausführungsbeispiel können bei der gewichteten Mittelwertbildung der zuletzt gespeicherte Ladezustand SOCₐₗₜ und der aktuelle Ladezustand gleichgewichtet werden. Dies erlaubt eine besonders einfache Umsetzung der Berücksichtigung des letzten Ladezustands SOCₐₗₜ.

In einem anderen Ausführungsbeispiel kann die Gewichtung bei der gewichteten Mittelwertbildung in Abhängigkeit von der Zeitdauer zwischen letzter Speicherung des Ladezustands SOCₐₗₜ und der Ermittlung des aktuell berechneten Ladezustands SOCₐₖₜ erfolgen. Diese Implementierung ermöglicht es, bei der Ermittlung des Ladezustandschätzwertes SOC_{schätz} die vergangene Zeit zwischen letztem Abschalten und Anschalten des Systems zu berücksichtigen.

Während der Initialisierung der ersten Messwerterfassung von Leerlaufspannung und Strom nach dem Start der Batterie können vorteilhafterweise die zuletzt gespeicherten Batteriegrößen direkt als Initialisierungswerte der entsprechenden Batteriegrößen verwendet werden.

Während eines Abschaltens und/oder während des Betriebs des Batteriemanagementsystems können zudem die ermittelten Batteriekenngrößen umfassend den Ladezustand der Batterie im nichtflüchtigen Speicher der Batterie gespeichert werden und stehen somit bei Systemstart dem Batteriemanagementsystem zur Verfügung. Auch Batteriegrößen wie Spannung, Temperatur und Modellparameter eines mathematischen Alterungsprozesses können dabei abgespeichert werden.

Des Weiteren kann während des Betriebs der Batterie eine Anpassung des Ladezustandsschätzwertes SOC_{schätz} über mehrere Messwertzyklen erfolgen, d.h. die abgespeicherten Batteriekenngrößen können permanent in die Berechnung des Ladezustands der Batterie während des Betriebs mit einfließen. Da einzelne Spannungs- oder Temperaturmessungen auch ausfallen können, kann die Ermittlung über mehrere Fahrzyklen weitergeführt werden, wenn die ermittelten Größen beim Abschalten des Systems abgespeichert werden.

Die Anpassung des Ladezustandschätzwertes SOC_{schätz} kann unter Verwendung eines mathematischen Alterungsmodells erfolgen. Die Eingangsgrößen des Alterungsmodells können dabei die gemessene Spannung, Temperatur, der integrierte Ladestrom und der Ladezustand SOCₐₗₜ beim letzten Abschalten der Batterie sein sowie die Stillstands-Dauer, die gemessene Spannung, Temperatur und der aktuelle Ladezustand SOCₐₖₜ bei Systemstart. Solche mathematischen Alterungsprozesse können mittels Zeitreihen beschrieben werden. Die Anpassung kann auch durch bekannte Adaptionsverfahren wie z.B. die Kalman-Filterung durchgeführt werden, die zur Durchführung lediglich die gespeicherten Werte und die bei den Systemstarts gemessenen und berechneten Werte verwenden.

Zusammenfassend ist festzuhalten, dass erfindungsgemäß beim Abschalten des Batteriemanagementsystems ermittelte und/oder gemessene Größen wie SOC, Modellparameter, Spannung, Temperatur etc. im nichtflüchtigen Speicher der Batterie, wie z.B. einem EEPROM, wahlweise für jede einzelne Zelle, abgespeichert werden und beim nächsten Systemstart zur Verfügung stehen. Beim nächsten Systemstart werden diese Größen mit den dann aktuellen Messgrößen und daraus berechneten Modellgrößen verglichen und zur Ermittlung von SOC und Modellparametern verwendet. Diese Werte können wahlweise nur zur Ermittlung der Initialwerte oder permanent verwendet werden. Abhängig von der Verfügbarkeit einzelner Messwerte beim Systemstart können die gespeicherten Werte als Rückfall-Lösung verwendet werden. Dabei sind mehrere Rückfallstufen möglich, die auch von Zelle zu Zelle unterschiedlich sind.

Im Folgenden soll die Erfindung anhand von Zeichnungen exemplarisch näher erläutert werden. Es zeigen:
- Fig. 1:: ein Schema ein erstes Ausführungsbeispiel des erfindungsgemäßen Verfahrens;
- Fig. 2:: ein Schema eines zweiten Ausführungsbeispiel des erfindungsgemäßen Verfahrens;

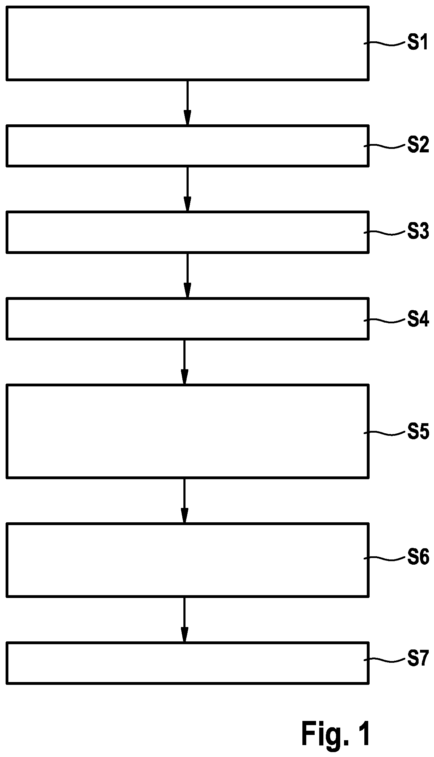

Fig. 1 zeigt ein Schema eines ersten Ausführungsbeispiels der vorliegenden Erfindung. So werden beim Abschalten oder shut down des Batteriemanagementsystems BMS zunächst der Ladezustand SOCₐₗₜ abgespeichert. Es können auch weitere relevante Größen wie Alterungs-Kenngrößen, Spannung und Temperatur im nichtflüchtigen Speicher der Batterie abgelegt werden. Dabei ist zu beachten, dass das BMS auch während des Aufladens der Batterie läuft.

Wie in Fig. 1 gezeigt, werden in den Schritten S1 und S2 beim nächsten Systemstart diese Werte aus dem nichtflüchtigen Speicher gelesen. Dabei kann vorteilhafterweise unter Verwendung eines sogenannten "dirty bits" festgestellt werden, ob die gespeicherten Werte gültig sind. Im Falle eines Rücksetzens des BMS kann es vorkommen, dass die Speicherwerte nicht geschrieben werden können. Dann ermöglicht das Setzen oder Nicht-setzen des "dirty bits" die Feststellung, ob die Werte korrekt geschrieben werden konnten.

Daraufhin wird die Leerlaufspannung OCV im Schritt S3 ohne Last an der Batterie während des Systemstarts gemessen. Daraufhin wird in S4 der Ladezustand SOCₐₖₜ aktuell ermittelt. Dieser Ladezustand beruht auf aktuellen Messwerten und kann auch Ladezustandsmesswert genannt werden. Er wird im vorliegenden Ausführungsbeispiel unter Verwendung der gemessenen Leerlauf-Spannung und eines Temperatur/OCV-abhängigen Kennfeldes bestimmt oder berechnet. Das Kennfeld trägt den Ladezustand als Funktion der gemessenen Leerlaufspannung auf. Dies geschieht bevorzugt temperaturabhängig, d.h. das Kennfeld beinhaltet bevorzugt mehrere Graphen, die dem Ladezustand als Funktion der Leerlaufspannung bei einer bestimmten Temperatur entsprechen. Es wird also aus einer gemessenen Leerlaufspannung, bevorzugt bei einer bestimmten Temperatur, aus dem Kennfeld automatisch der zugehörige Ladezustand abgelesen bzw. ermittelt.

Nach Berechnung oder Bestimmung des aktuellen Ladezustandwertes SOCₐₖₜ erfolgt die Ermittlung eines Ladezustandsschätzwertes SOC_{schätz} im Schritt S5. Dies erfolgt unter Verwendung des gespeicherten Ladezustands SOCₐₗₜ sowie des aktuell ermittelten Ladezustands SOCₐₖₜ. Im einfachsten Fall kann der Initialisierungswert für den SOC durch Mittelwertbildung vom gespeicherten SOCₐₗₜ und dem aktuell ermittelten SOCₐₖₜ erfolgen. Die Gewichtung kann dabei durch Gleichgewichtung erfolgen oder es kann die Zeitdauer zwischen Abschalten und Einschalten des Systems bei der Gewichtung berücksichtigt werden.

Daraufhin wird das Batteriemanagementsystem mit diesem Schätzwert initialisiert, siehe Schritt S6, und das System in Schritt S7 betrieben.

Ferner können, solange die erste Messwert-Erfassungen von Spannung und Strom initialisiert werden, die Speicherwerte direkt als Initialisierungswerte verwendet werden. Wenn ein Spannungs-Messwert ungültig ist so kann in diesem Fall dieser durch die gespeicherte Spannung initialisiert werden und anschließend mit gleichbleibender Differenz zum Mittelwert der gültigen Spannungs-Messwerte abgeschätzt werden. Es könnte dazu der Offset der Spannungsmessung bestimmt werden und dann der Spannungssensor-Ausgang mit diesem Offset korrigiert werden.

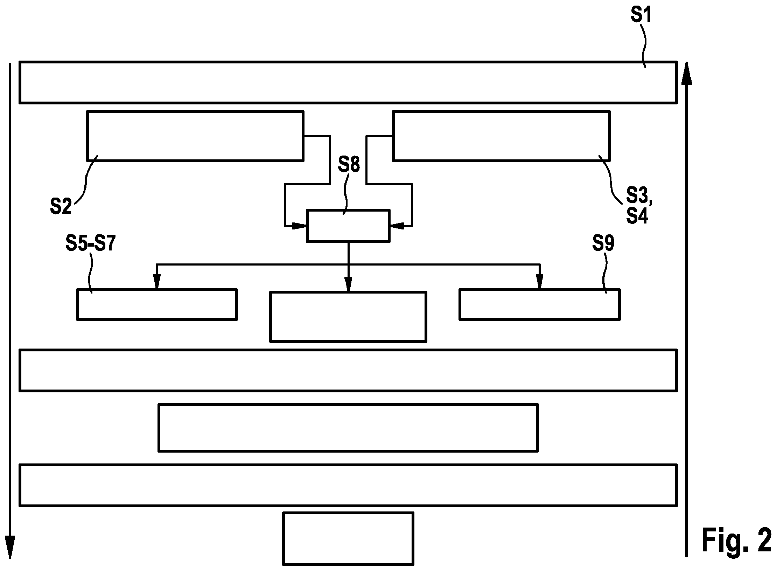

Fig. 2 zeigt ein weiteres Ausführungsbeispiel der Erfindung mit erweiterten Funktionen. So wird in einem zwischengeschalteten Schritt S8 der SOC-Speicherwert SOCₐₗₜ mit dem aktuell berechneten Ladezustandswert SOCₐₖₜ verglichen. Weicht der gespeicherte Ladezustand SOCₐₖₜ stark vom berechneten SOCₐₖₜ ab, liegt also über einem vorbestimmten Schwellenwert, so weist dies auf einen Systemfehler oder Defekt hin. Diese Information kann im Schritt S9 zur Fehlererkennung und zum sofortigen Abschalten genutzt werden oder durch weitere Messungen während des Betriebs zunächst plausibilisiert werden. Diese weitere Plausibilisierung kann z.B. durch Vergleich des OCV-abhängigen berechneten SOCs mit einem Strom-Integral geschehen.

Ist die Abweichung nur gering, liegt sie also unterhalb eines vorbestimmten Schwellenwertes, so könnte auch die Alterung dieser Zelle die Ursache sein. In diesem Fall kann die geschätzte Kapazität dieser Zelle korrigiert werden. Um diese Auswertung robuster zu machen, können auch gefilterte Abweichungen über mehrere Zyklen gebildet werden. Eine andere Alternative stellen komplexere Algorithmen wie der Kalman-Filter dar, bei dem in diesem Anwendungsbeispiel die gemessene Spannung, Temperatur, integrierter Ladestrom und der berechnete SOC bei shut-down, die Stillstands-Dauer, die gemessene Spannung, Temperatur und der berechnete SOC bei Systemstart als Eingangsgrößen eines Alterungsmodells dienen könnten und eine Korrektur der Zellen-Kapazität und der Impedanz-Modell-Parameter die Ausgangsgrößen bilden.

Während des Betriebes wird die Änderung des SOC im Allgemeinen durch Integration des Stroms und oder Auswerten des Zusammenhangs zwischen OCV und SOC berechnet. Dabei wird die OCV ermittelt, indem die aktuelle Zellspannung um den Spannungsabfall korrigiert wird, der durch den fließenden Strom und die Zellen-Impedanz verursacht wird. Dies geschieht auch im vorliegenden Ausführungsbeispiel während des Betriebs der Batterie.

Sowohl Zellen-Impedanz als auch die Zellen-Kapazität sowie der Zusammenhang zwischen OCV und SOC unterliegen einem Alterungsprozess. Durch den Vergleich der Werte, die nach dem shut down im Speicher gespeichert wurden, mit den Werten, die beim Systemstart gemessen und ermittelt werden, lässt sich der aktuelle Alterungszustand abschätzen.

## Patentansprüche

1. Verfahren zur Initialisierung und zum Betrieb eines Batteriemanagementsystems, umfassend die Schritte:
Starten des Batteriemanagementsystems (S1);
Auslesen von in einem nichtflüchtigen Speicher der Batterie gespeicherten Batteriegrößen umfassend den letzten Ladezustand (SOCₐₗₜ) der Batterie (S2);
Messung der Leerlaufspannung der Batterie (S3);
Ermittlung eines aktuellen Ladezustandwertes (SOCₐₖₜ) in Abhängigkeit von der gemessenen Leerlaufspannung (S4);
Ermittlung eines Schätzwertes des Ladezustands (SOC_{schätz}) der Batterie als Funktion sowohl des gespeicherten letzten Ladezustands (SOCₐₗₜ) der Batterie als auch des aktuellen Ladezustandswertes (SOCₐₖₜ) (S5);
Initialisierung des Ladezustands im Batteriemanagementsystems mit dem ermittelten Schätzwertes des Ladezustands (SOC_{schätz}) (S6); und
Betrieb des Batteriemanagementsystems mit den initialisierten Werten (S7), **gekennzeichnet dadurch, dass** eine Plausibilisierung der Zustandserkennung des Batteriemanagementsystems erfolgt, umfassend die Schritte:
Vergleich von aktuellem Ladezustand (SOCₐₖₜ) und zuletzt gespeichertem Ladezustand (SOCₐₗₜ) (S8);
Abschalten der Batterie, wenn die Differenz aus dem aktuellen Ladezustand (SOCₐₖₜ) und dem zuletzt gespeicherten Ladezustand (SOCₐₗₜ) über einem vorbestimmten Schwellenwert liegt (S9); oder
Initialisierung des Batteriemanagementsystems mit dem ermittelten Schätzwertes des Ladezustands (SOC_{schätz}) wenn die Differenz aus aktuellem Ladezustands (SOCₐₖₜ) und zuletzt gespeicherten Ladezustand (SOCₐₗₜ) unter dem vorbestimmten Schwellenwert liegt (S6),
wobei vor dem Abschalten des Batteriemanagementsystems oder der Initialisierung ferner eine weitere Plausibilisierung der Werte mittels eines Vergleichs des Leerlaufspannungs-abhängigen berechneten Ladezustand (SOCₐₖₜ) mit einem Strom-Integral erfolgt.

2. Verfahren nach Anspruch 1, wobei die Ermittlung des aktuellen Ladezustands (SOCₐₖₜ) mittels der gemessenen Leerlaufspannung und eines Temperatur/Leerlaufspannungs-abhängigen Kennfeldes erfolgt.

3. Verfahren nach einem der vorhergehenden Ansprüche, wobei die Ermittlung des Ladezustandschätzers (SOC_{schätz}) durch gewichtete Mittelwertbildung aus dem gespeicherten letzten Ladezustand (SOCₐₗₜ) und dem aktuellen Ladezustand (SOCₐₖₜ) erfolgt.

4. Verfahren nach Anspruch 3, wobei bei der gewichteten Mittelwertbildung der zuletzt gespeicherte Ladezustand (SOCₐₗₜ) und der aktuelle Ladezustand (SOCₐₖₜ) gleichgewichtet werden.

5. Verfahren nach Anspruch 1 oder 2, wobei die Gewichtung bei der gewichteten Mittelwertbildung in Abhängigkeit von der Zeitdauer zwischen letzter Speicherung des Ladezustands (SOCₐₗₜ) und der Ermittlung des aktuellen Ladezustands (SOCₐₖₜ) erfolgt.

6. Verfahren nach einem der vorhergehenden Ansprüche, wobei während der Initialisierung der ersten Messwerterfassung von Leerlaufspannung und Strom nach dem Start der Batterie die zuletzt gespeicherten Batteriegrößen direkt als Initialisierungswerte der entsprechenden Batteriegrößen verwendet werden.

7. Verfahren nach einem der vorhergehenden Ansprüche, wobei während eines Abschaltens und/oder des Betriebs des Batteriemanagementsystems die ermittelten Batteriekenngrößen umfassend den Ladezustand der Batterie im nichtflüchtigen Speicher der Batterie gespeichert werden und/oder Batteriegrößen wie Spannung, Temperatur und Modellparameter eines mathematischen Alterungsprozesses abgespeichert werden.

8. Verfahren nach einem der vorhergehenden Ansprüche, wobei ferner während des Betriebs der Batterie eine Anpassung des Ladezustandsschätzers (SOC_{schätz}) über mehrere Messwertzyklen erfolgt.

9. Verfahren nach Anspruch 8, wobei die Anpassung des Ladezustands unter Verwendung von folgenden Eingangsgrößen eines Alterungsmodells erfolgt:
der gemessenen Spannung, Temperatur, dem integrierte Ladestrom und Ladezustandswertes (SOCₐₗₜ) beim letzten Abschalten der Batterie; sowie
der Stillstands-Dauer, der gemessenen Spannung, Temperatur und aktuellen Ladezustand (SOCₐₖₜ) bei Systemstart.

## Claims

1. Method for initializing and operating a battery management system, comprising the steps of:
starting the battery management system (S1);
reading battery variables which are stored in a nonvolatile memory of the battery and comprise the last state of charge (SOC_{old}) of the battery (S2);
measuring the open-circuit voltage of the battery (S3);
determining an instantaneous state of charge value (SOCᵢₙₛₜ) on the basis of the measured open-circuit voltage (S4);
determining an estimated value of the state of charge (SOCₑₛₜ) of the battery as a function of both the stored last state of charge (SOC_{old}) of the battery and the instantaneous state of charge value (SOCᵢₙₛₜ) (S5);
initializing the state of charge in the battery management system using the determined estimated value of the state of charge (SOCₑₛₜ) (S6); and
operating the battery management system with the initialized values (S7),
**characterized in that**
a plausibility check of the state detection by the battery management system is also carried out, comprising the steps of:
comparing the instantaneous state of charge (SOCᵢₙₛₜ) and the state of charge stored last (SOC_{old}) (S8) ;
switching off the battery if the difference between the instantaneous state of charge (SOCᵢₙₛₜ) and the state of charge stored last (SOC_{old}) is above a predetermined threshold value (S9); or
initializing the battery management system with the determined estimated value of the state of charge (SOCₑₛₜ) if the difference between the instantaneous state of charge (SOCᵢₙₛₜ) and the state of charge stored last (SOC_{old}) is below the predetermined threshold value (S6), wherein, before the battery management system is switched off or before initialization, a further plausibility check of the values is also carried out by comparing the calculated state of charge (SOCᵢₙₛₜ) dependent on the open-circuit voltage with a current integral.

2. Method according to Claim 1, wherein the instantaneous state of charge (SOCᵢₙₛₜ) is determined using the measured open-circuit voltage and a family of characteristics dependent on the temperature/open-circuit voltage.

3. Method according to one of the preceding claims, wherein the state of charge estimator (SOCₑₛₜ) is determined by means of weighted averaging of the stored last state of charge (SOC_{old}) and the instantaneous state of charge (SOCᵢₙₛₜ).

4. Method according to Claim 3, wherein the state of charge stored last (SOC_{old}) and the instantaneous state of charge (SOCᵢₙₛₜ) are balanced during the weighted averaging operation.

5. Method according to one of Claims 1 or 2, wherein the weighting operation is carried out in the weighted averaging operation on the basis of the period of time between the last storage of the state of charge (SOC_{old}) and the determination of the instantaneous state of charge (SOCᵢₙₛₜ).

6. Method according to one of the preceding claims, wherein, during the initialization of the first measured value acquisition of the open-circuit voltage and current after the battery has been started, the battery variables stored last are directly used as initialization values of the corresponding battery variables.

7. Method according to one of the preceding claims, wherein the determined battery characteristic variables comprising the state of charge of the battery are stored in the nonvolatile memory of the battery and/or battery variables such as voltage, temperature and model parameters of a mathematical ageing process are stored while switching off and/or operating the battery management system.

8. Method according to one of the preceding claims, wherein the state of charge estimator (SOCₑₛₜ) is also adapted over a plurality of measured value cycles during operation of the battery.

9. Method according to Claim 8, wherein the state of charge is adapted using the following input variables of an ageing model:
the measured voltage, the temperature, the integrated charging current and the state of charge value (SOC_{old}) during the last operation of switching off the battery, and
the standstill duration, the measured voltage, the temperature and the instantaneous state of charge (SOCᵢₙₛₜ) when starting the system.

## Revendications

1. Procédé pour initialiser et pour faire fonctionner un système de gestion de batterie, comprenant les étapes suivantes :
démarrage du système de gestion de batterie (S1) ;
chargement de grandeurs de batterie enregistrées dans une mémoire non volatile de la batterie, comprenant le dernier état de charge (SOCₐₗₜ) de la batterie (S2) ;
mesure de la tension à vide de la batterie (S3) ;
détermination d'un état de charge actuel (SOCₐₖₜ) en fonction de la tension à vide mesurée (S4) ;
détermination d'une valeur estimée de l'état de charge (SOC_{schätz}) de la batterie en fonction à la fois du dernier état de charge (SOCₐₗₜ) enregistré de la batterie et de l'état de charge actuel (SOCₐₖₜ) (S5) ;
initialisation de l'état de charge dans le système de gestion de batterie avec la valeur estimée de l'état de charge (SOC_{schätz}) déterminée (S6) ; et
fonctionnement du système de gestion de batterie avec les valeurs initialisées (S7),
**caractérisé en ce que**
une vérification de la plausibilité de la reconnaissance d'état du système de gestion de batterie est effectuée,
comprenant les étapes suivantes :
comparaison de l'état de charge actuel (SOCₐₖₜ) et du dernier état de charge (SOCₐₗₜ) enregistré (S8) ;
mise hors circuit de la batterie lorsque la différence entre l'état de charge actuel (SOCₐₖₜ) et le dernier état de charge (SOCₐₗₜ) enregistré est supérieure à une valeur de seuil prédéfinie (S9) ; ou
initialisation du système de gestion de batterie avec la valeur estimée de l'état de charge (SOC_{schätz}) déterminée lorsque la différence entre l'état de charge actuel (SOCₐₖₜ) et le dernier état de charge (SOCₐₗₜ) enregistré et inférieure à la valeur de seuil prédéfinie (S6),
une vérification supplémentaire de la plausibilité des valeurs étant effectuée avant la mise hors circuit du système de gestion de batterie ou l'initialisation au moyen d'une comparaison de l'état de charge (SOCₐₖₜ) calculé en fonction de la tension à vide avec une intégrale du courant.

2. Procédé selon la revendication 1, la détermination de l'état de charge actuel (SOCₐₖₜ) étant effectuée au moyen de la tension à vide mesurée et d'un diagramme caractéristique dépendant de la température/tension à vide.

3. Procédé selon l'une des revendications précédentes, la détermination de l'estimateur d'état de charge (SOC_{schätz}) étant effectuée par un calcul de la moyenne pondérée du dernier état de charge (SOCₐₗₜ) enregistré et de l'état de charge actuel (SOCₐₖₜ).

4. Procédé selon la revendication 3, le dernier état de charge (SOCₐₗₜ) enregistré et l'état de charge actuel (SOCₐₖₜ) étant équilibrés lors du calcul de la moyenne pondérée.

5. Procédé selon la revendication 1 ou 2, la pondération lors du calcul de la moyenne pondérée étant effectuée en fonction de la durée entre le dernier enregistrement de l'état de charge (SOCₐₗₜ) et la détermination de l'état de charge actuel (SOCₐₖₜ).

6. Procédé selon l'une des revendications précédentes, les dernières grandeurs de batterie enregistrées étant utilisées directement en tant que valeurs d'initialisation des grandeurs de batterie correspondantes pendant l'initialisation de la première acquisition de valeur mesurée de la tension à vide et du courant après de démarrage de la batterie.

7. Procédé selon l'une des revendications précédentes, les grandeurs caractéristiques de batterie déterminées, comprenant l'état de charge de la batterie, étant enregistrées dans la mémoire non volatile de la batterie et/ou des grandeurs de batterie telles que la tension, la température ou des paramètres de modèle d'un processus de vieillissement mathématique étant mémorisés pendant une mise hors circuit et/ou le fonctionnement du système de gestion de batterie.

8. Procédé selon l'une des revendications précédentes, une adaptation de l'estimateur d'état de charge (SOC_{schätz}) sur plusieurs cycles de valeurs mesurées étant en outre effectuée pendant le fonctionnement de la batterie.

9. Procédé selon la revendication 8, l'adaptation de l'état de charge étant effectuée en utilisant les grandeurs d'entrée suivantes :
la tension mesurée, la température, le courant de charge intégré et la valeur de l'état de charge (SOCₐₗₜ) à la dernière mise hors circuit de la batterie ; ainsi que
la durée d'arrêt, la tension mesurée, la température et l'état de charge actuel (SOCₐₖₜ) au démarrage du système.
